(19) Europäisches Patentamt / European Patent Office / Office européen des brevets

(11) **EP 4 109 039 A1**

(12) **EUROPEAN PATENT APPLICATION**

(43) Date of publication:
**28.12.2022 Bulletin 2022/52**

(21) Application number: **21211062.1**

(22) Date of filing: **29.11.2021**

(51) International Patent Classification (IPC):
**G01B 11/25** (2006.01)    **G02B 27/09** (2006.01)

(52) Cooperative Patent Classification (CPC):
**G01B 11/254; G01B 11/2513; G02B 27/0905; G02B 27/0944**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.06.2021 US 202117358011**

(71) Applicant: **Himax Technologies Limited
Tainan City 74148 (TW)**

(72) Inventor: **HSIAO, Ming-Shu
74148 Tainan City (TW)**

(74) Representative: **Hoefer & Partner Patentanwälte mbB
Pilgersheimer Straße 20
81543 München (DE)**

Remarks:
Amended claims in accordance with Rule 137(2) EPC.

(54) **DOT PATTERN PROJECTOR FOR USE IN THREE-DIMENSIONAL DISTANCE MEASUREMENT SYSTEM**

(57) A dot pattern projector (100) includes a light source array (120), a lens (140) and a diffracting unit (160). The light source array (120) includes a plurality of light sources (120_1, 120_2) that emit light beams. The lens (140) is configured to collimate the light beams. The diffracting unit (160) is configured to diffract the collimated light beams thereby to project an illumination pattern, wherein the illumination pattern is formed by overlapping multiple dot patterns that are projected by different light sources (120_1, 120_2) or interlacing multiple dot patterns that are projected by different light sources (120_1, 120_2).

FIG. 3

EP 4 109 039 A1

## Description

Field of the Invention

The present invention relates to three-dimensional optical distance measurement, and more particularly to, a dot pattern projector for use in a three-dimensional optical distance measurement system.

Background of the Invention

Typically, three-dimensional optical distance measurement based on time-of-flight (ToF) technology relies on a flood illuminator in conjunction with an imaging sensor to provide distance measurements of an object or shape. However, a distance of projection of the flood illuminator is pretty short due to its weak optical energy.
In view of this, there is a need to provide a pattern projector which can provide high-power illumination pattern as well as considerable distance of projection.

Summary of the Invention

With this in mind, it is one object of the present invention to provide a regular dot pattern projector for use in a three-dimensional optical distance measurement system. Embodiments of the present invention may rely on a light source array in conjunction with a lens as well as a diffracting unit to produce illumination pattern with regularly distributed dots. Embodiments of the present invention allow dot patterns produced by different light sources of the light source array to be overlapped or interlaced thereby to form the illumination pattern. According to various embodiments, the diffracting unit may be implemented with a microlens array (MLA) or a diffractive optical element (DOE). Due to flexibility provided by different interfacing types of embodiments of the present invention, parameters of components of the dot pattern projector will have wide ranges of adjustment. This significantly improves the flexibility of the design and the fabrication of the dot pattern projector.
This is achieved by a dot pattern projector according to claim 1, and an optical distance measurement system to claim 11. The dependent claims pertain to corresponding further developments and improvements.
As will be seen more clearly from the detailed description following below, a dot pattern projector is disclosed. The dot pattern projector comprises: a light source array, a lens and a diffracting unit. The light source array includes a plurality of light sources that emit light beams. The lens is configured to collimate the light beams. The diffracting unit is configured to diffract the collimated light beams thereby to project an illumination pattern. The illumination pattern is formed by overlapping multiple dot patterns that are projected by different light sources or interlacing multiple dot patterns that are projected by the light sources.
As will be seen more clearly from the detailed description following below, an optical distance measurement system is disclosed. The optical distance measurement system comprises: a flood illuminator, a dot pattern projector and an image capturing device. The flood illuminator includes at least one light source and a diffuser. The flood illuminator is configured to project a first illumination pattern. The dot pattern projector is configured to project a second illumination pattern. The dot pattern projector comprises: a light source array, a lens and a diffracting unit. The light source array includes a plurality of light sources that emit light beams. The lens is configured to collimate the light beams. The diffracting unit is configured to diffract the collimated light beams thereby to project an illumination pattern, wherein the illumination pattern are formed by overlapping multiple dot patterns that are projected by different light sources or interlacing multiple dot patterns that are projected by different light sources. The image capturing device is configured to capture images of light pattern reflected from an object.

Brief Description of the Drawings

FIG. 1 illustrates a schematic diagram of an optical distance measurement system according to one embodiment of the present invention.
FIG. 2 illustrates an implementation of a dot pattern projector and a flood illuminator according to one embodiment of the present invention.
FIG. 3 illustrates a detailed schematic diagram of a dot pattern projector according to one embodiment of the present invention.
FIGS. 4A-4E illustrate how an illumination pattern is formed by overlapping dot patterns according to one embodiment of the present invention.
FIGS. 5A-5E illustrate how an illumination pattern is formed by interlacing dot patterns according to one embodiment of the present invention.
FIGS. 6A-6B illustrate how an arrangement of a light sources array affects a dot distribution of an illumination pattern according to different embodiments of the present invention.
FIG. 7 illustrate how arrangements of source arrays and microlens arrays, and an interlacing type affects dot distributions of the illumination pattern according to embodiments of the present invention.

Detailed Description

In the following description, numerous specific details are set forth in order to provide a thorough understanding of the present embodiments. It will be apparent, however, to one having ordinary skill in the art that the specific detail need not be employed to practice the present embodiments. In other instances, well-known materials or methods have not been described in detail in order to avoid obscuring the present embodiments.

Reference throughout this specification to "one embodiment" or "an embodiment" means that a particular feature, structure or characteristic described in connection with the embodiment or example is included in at least one embodiment of the present embodiments. Thus, appearances of the phrases "in one embodiment" or "in an embodiment" in various places throughout this specification are not necessarily all referring to the same embodiment. Furthermore, the particular features, structures or characteristics may be combined in any suitable combinations and/or sub-combinations in one or more embodiments.

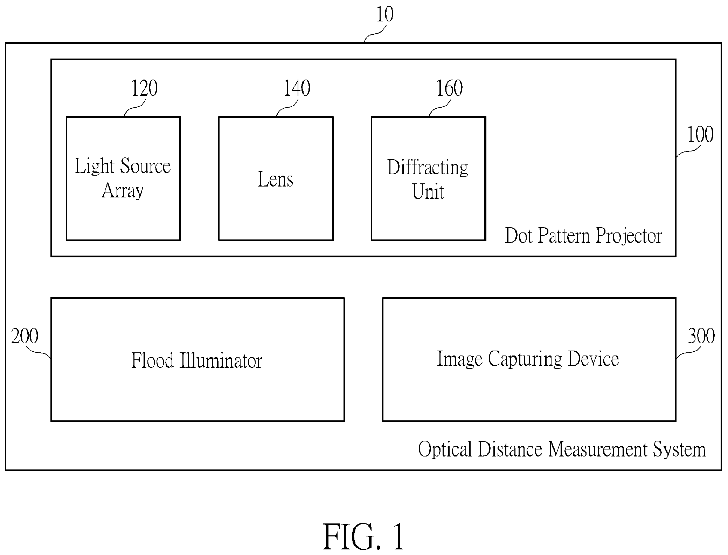

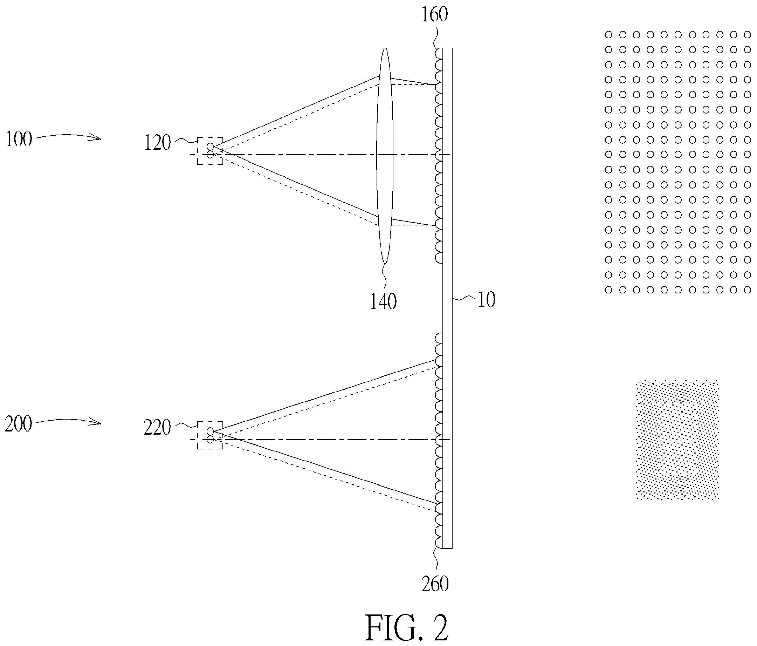

Please refer to FIG. 1, which illustrates a schematic diagram of an optical distance measurement system 1 according to one embodiment of the present invention. As illustrated, the optical distance measurement system 1 comprises a dot pattern projector 100, a flood illuminator 200 and an image capturing device 300. Both of the dot pattern projector 100 and the flood illuminator 200 are configured to project high-power illumination patterns onto an object within a field of view of the image capturing device 300. According to various embodiments of the present invention, the dot pattern projector 100 and the flood illuminator 200 may project different types of illumination patterns sequentially or simultaneously. FIG. 2 illustrates a possible arrangement of the dot pattern projector 100 and the flood illuminator 200. As illustrated, the dot pattern projector 100 (which comprises a light source 120, a collimated lens 140, a diffracting unit 160, and projects a dot illumination pattern) and the flood illuminator 200 (which comprises a light source 220 and a diffracting unit 260, and projects a flood illumination pattern) share a same substrate. The dot pattern projector 100 and the flood illuminator 200 may use separate diffracting units 160 and 260, both of which are disposed on a shared substrate 10. The diffracting unit 160 of the dot pattern projector 100, which may be a microlens array or an optical diffracting unit (DOE), is disposed on the shared substrate 10 that the diffracting unit 260 (which may be a microlens array or an optical diffracting unit (DOE)) of the flood illuminator 200 is disposed on. An advantage of sharing a same substrate and arranging two diffracting unit adjacent to each other is to reduce the complexity of manufacturing process. In this regards, etching or mold reversal of the dot pattern projector 100 and the flood illuminator 200 can be done together, which makes the cost lower, and also reduces the assembly time.

The image capturing device 300 may comprise (but not limited to) a focusing lens, a filter and an image sensor, such as, a complementary metal-oxide semiconductor (CMOS) or a charge-coupled device (CCD) sensor (not shown). The image capturing device 300 is configured to capture images of illumination patterns reflected from the object. According to the images captured by the image sensor 300, depth information regarding the object can be measured.

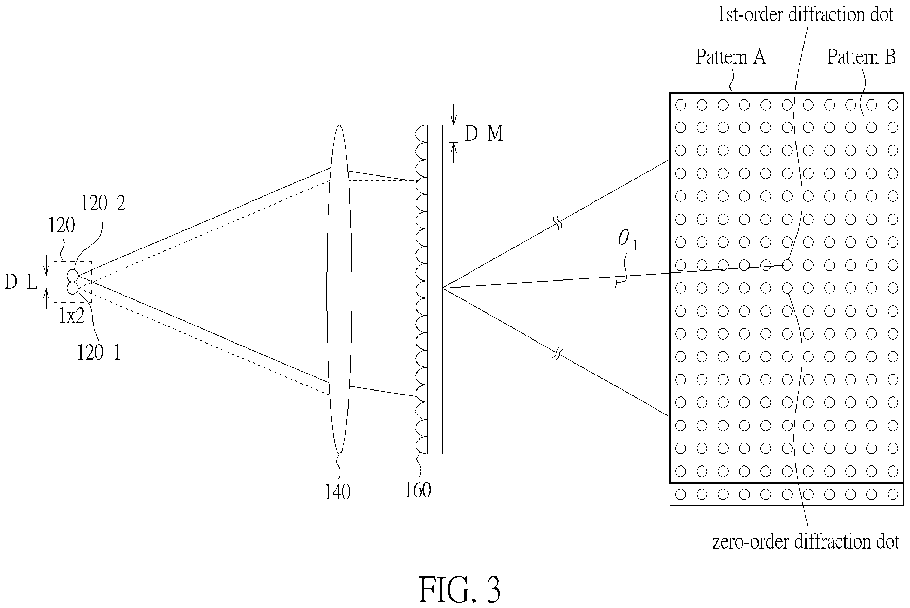

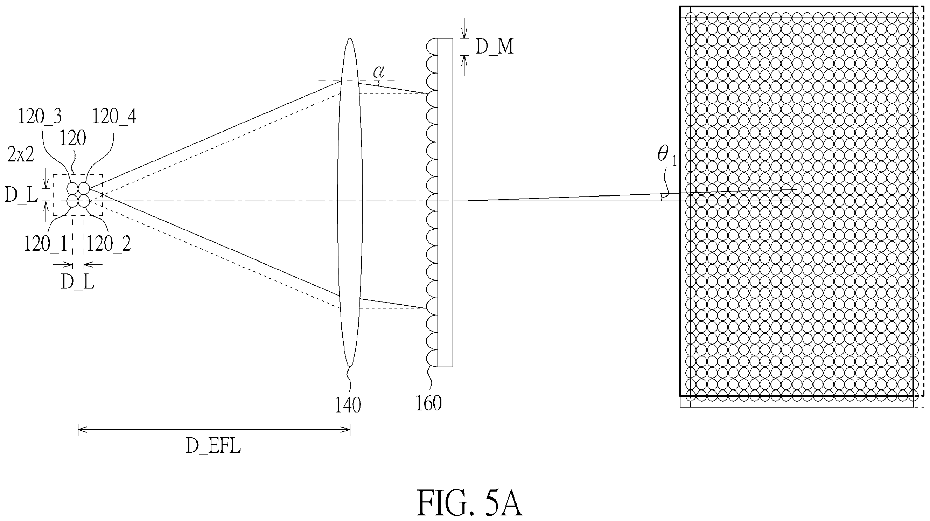

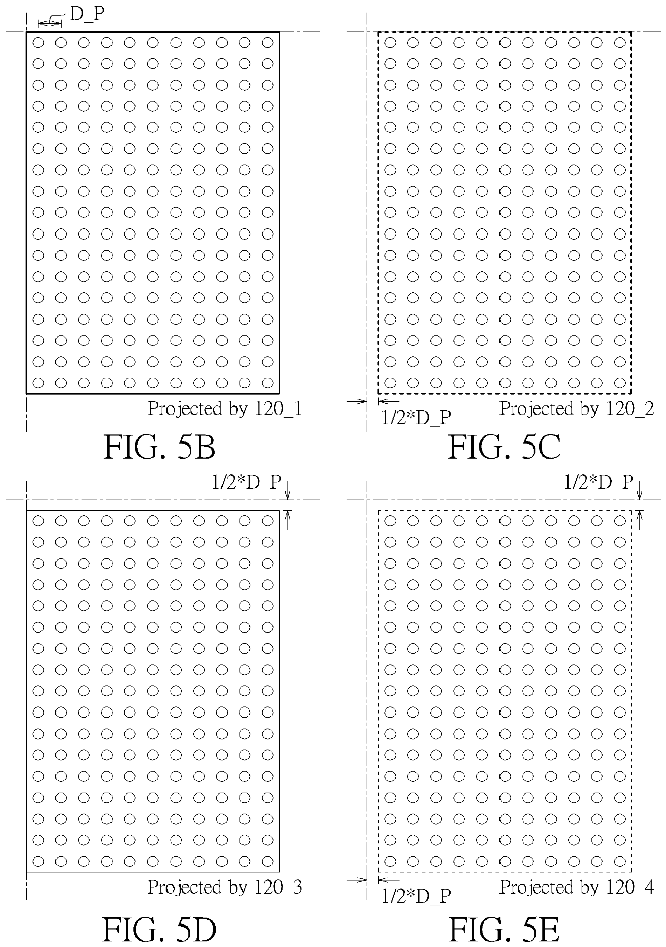

FIG. 3 illustrates a schematic diagram of the dot pattern projector 100 according to one embodiment of the present invention. As illustrated, the dot pattern projector 100 comprises a light source array 120, a lens 140 and a diffracting unit 160. The light source array 120 is arranged to emit light beams, and includes a plurality of light sources $120\_1$-$120\_N$ that are arranged in an array form. According to various embodiment, the light sources $120\_1$-$120\_N$ may be regularly distributed or hexagonally distributed as shown by FIG. 5A. Please note that the number of the light sources $120\_1$-$120\_N$ in the drawings is just for illustrative purpose only. Preferably, the light sources $120\_1$-$120\_N$ could be a vertical-cavity surface-emitting laser (VCSEL) and are equally separated by a pitch $D\_L$.

The lens 140 is arranged to collimate the light beams that are emitted by the light source array 120. Preferably, a distance between of the light source array 120 and an optical center of the lens 140 is identical to an effective focal length D EFL of the lens 140. Accordingly, with the lens 140, the light beams could be more condensed, thereby allowing dots in the illumination patterns projected by the dot pattern projector 100 to have smaller sizes and higher contrast. The diffracting unit 160 is configured to diffract the light beams thereby to project the illumination patterns having regularly distributed dots as shown by FIG. 2. According to various embodiments, the diffracting unit 160 could a diffraction optical element (DOE) or a microlens array (MLA).

In addition, the flood illuminator 200 may comprises a light source and a diffuser, and use a DOE or a MLA as the diffuser. In one embodiment, once the DOE is used as the diffracting unit 160 in the dot pattern projector 100, a DOE will also be used as the diffuser in the flood illuminator 200. On the other hand, once the MLA is used as the diffracting unit 160 in the dot pattern projector 100, a MLA will also be used as the diffuser in the flood illuminator 200. In the case where the MLA is used as the diffracting unit 160, the MLA 160 comprises a plurality of micro lenses that have a plano-convex shape and a lens pitch between two neighboring unit lenses of the MLA 160 is D M. In the case where the DOE is used as the diffracting unit 160, a cell pitch between neighboring unit cells of the DOE 160 is $D\_E$. In preferable embodiments, the lens pitch $D\_M$ of the MLA 160 or the cell pitch $D\_E$ of the DOE 160 could be larger than $10\mu m$, which is relatively easy for fabrication.

Distribution of dots projected by the light sources $120\_1$-$120\_N$ can be determined according to various parameters. In one embodiment, assuming that a fan-out angle between a dot of zero-order diffraction and a dot of mth-order diffraction of the dot pattern projected by a single light source is $\theta_m$ and a wavelength of the light beam emitted by the light sources is $\lambda$, a lens pitch of the MLA 160 is D M, there will be the following relationship between these parameters:

$$D\_M \times \sin\theta_m = m\lambda;$$

where m is the diffraction order. In view of this, the fan-out angle $\theta_1$ between a dot of the zero-order diffraction and a dot of the 1st-order diffraction of the dot pattern will be:

$$\theta_1 = \sin^{-1}\left(\frac{\lambda}{D\_M}\right).$$

In addition, as shown by FIG. 2, the dot pattern (pattern B) projected by the light source 120_2 that is not positioned at the optical axis of the lens 140 will be shifted in vertical direction compared to the dot pattern (pattern A) projected by the light source 120_1 that is positioned at the optical axis of the lens 140. According to various embodiments, the illumination pattern projected by dot pattern projector 100 is formed by overlapping or interlacing dot patterns projected by different light sources.

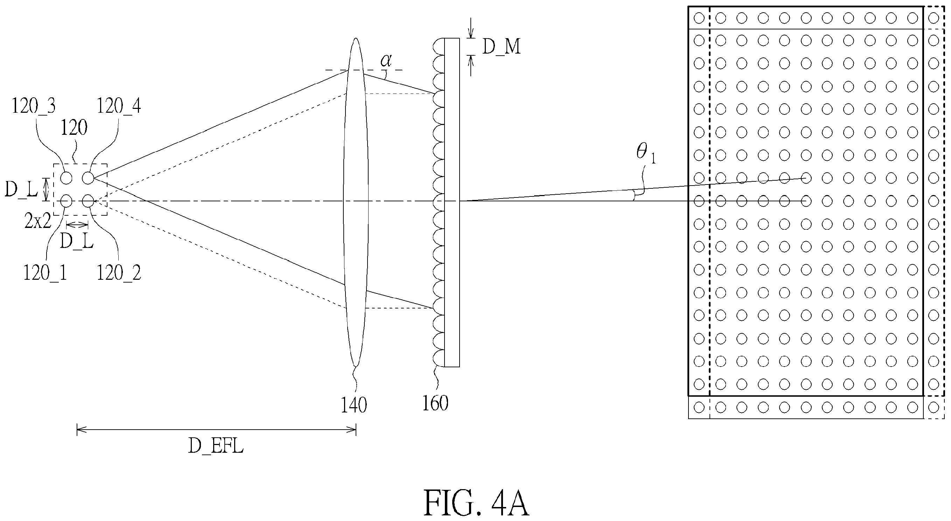

Please refer to FIGS. 4A-4E for understanding how the illumination pattern is formed by overlapping different dot patterns of different light sources according to one embodiment of the present invention. In such embodiment, the light source array 120 is a 2x2 array including light sources 120_1-120_4. FIG. 3B and FIG. 3C illustrate dot patterns produced by the light sources 120_1-120_2 that are positioned at the optical axis of the lens 140, while FIG. 3D and FIG. 3E illustrate dot patterns produced by the light sources 120_3-120_4 that are not positioned at the optical axis of the lens 140. The collimated light beams of light sources 120_3-120_4 will deviate from the optical axis of the lens by a deviation angle $\alpha$, where the deviation angle $\alpha$ can be determined by:

$$\alpha = \tan^{-1}\left(\frac{D\_L}{D\_EFL}\right);$$

(D_L is a pitch between the neighboring light sources; D_EFL is an effective focal length of the lens 140). Therefore, the dot patterns projected by the light sources 120_3-120_4 will be shifted in vertical direction compared to the dot patterns projected by the light sources 120_1-120_2.

In order to exactly overlap the dot patterns, it is necessary to have:

$$\sin\alpha = \sin\theta_1.$$

That is, the deviation angle $\alpha$ by which the collimated light beams of the light sources deviate from the optical axis needs to be identical to the fan-out angle $\theta_1$ between the dot of the zero-order diffraction and the dot of the 1st-order diffraction. If the light source pitch D_L, the effective focal length D_EFL and the lens pitch D_M (the diffracting unit 160 is a MLA) or the cell pitch D_E (if the diffracting unit 160 is a DOE) are well controlled to satisfy $\sin\alpha = \sin\theta$, the dot patterns will be shifted by exactly one dot pitch D_P (i.e., a distance between neighboring dots in the dot pattern) in vertical or horizontal direction compared to each other, thereby forming an overlapping-type illumination pattern.

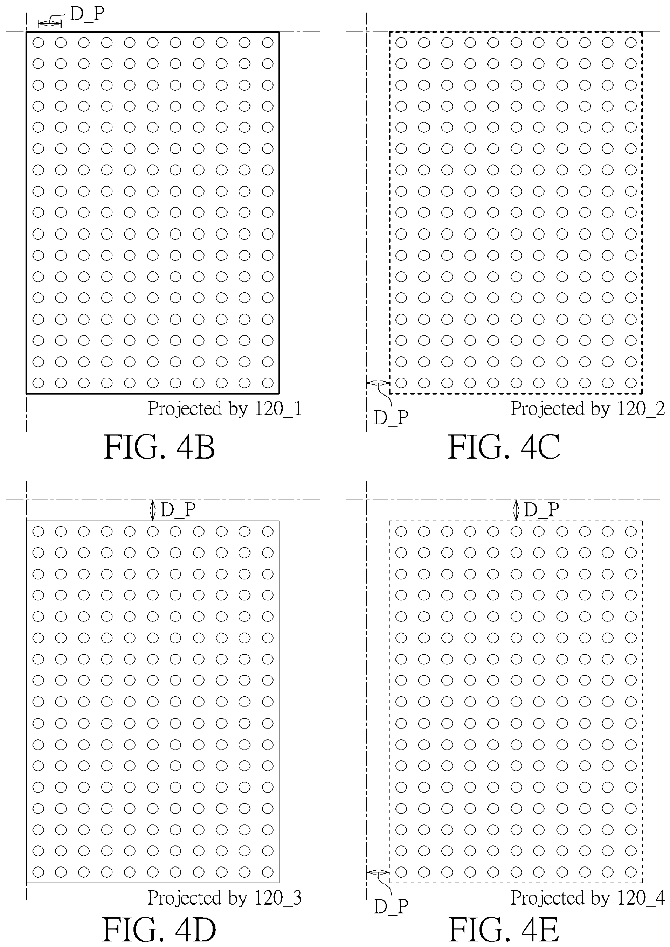

Please refer to FIGS. 5A-5E for understanding how the illumination pattern is formed by interlacing different dot patterns of different light sources according to one embodiment of the present invention. In such embodiment, the light source array 120 is a 2x2 array including light sources 120_1-120_4. FIG. 4B and FIG. 4C illustrate dot patterns produced by the light sources 120_1-120_2 that are positioned at the optical axis of the lens 140, while FIG. 4D and FIG. 4E illustrate dot patterns produced by the light sources 120_3-120_4 that are not positioned at the optical axis of the lens 140. The collimated light beams of light sources 120_3-120_4 will deviate from the optical axis of the lens by the deviation angle $\alpha$, where the deviation angle $\alpha$ is also determined by:

$$\alpha = \tan^{-1}\left(\frac{D\_L}{D\_EFL}\right).$$

In order to interlacing the dot patterns, it is necessary to have:

$$N \times \sin\alpha = \sin\theta.$$

An interfacing factor N will determine how dot patterns are interlaced. In a case where N is 1, the dot pattern projected by the light sources that are not positioned at the optical axis will be shifted by one dot pitch D_P in vertical or horizontal direction compared to each other, thereby forming the overlapping-type illumination pattern as shown by FIG. 3A. In a case where N is 2, the dot pattern projected by the light sources that are not positioned at the optical axis will be shifted by 1/2 dot pitch D_P in vertical or horizontal direction compared to each other, thereby forming the interlacing-type illumination pattern as shown by FIG. 4A. In a case where N is 3, the dot pattern projected by the light sources that are not positioned at the optical axis will be shifted by 1/3 dot pitch D_P in vertical or horizontal direction compared to each other, which also forms the interlacing-type illumination pattern.

In view of above, the lens pitch D_M of diffracting unit 160 (if the diffracting unit 160 is a MLA) or the cell pitch D_E of the diffracting unit 160 (if the diffracting unit 160 is a DOE) can determine the fan-out angle $\theta$, which affects dot distributions (e.g., dot density) of the dot pattern projected by a single light source. In addition, the light source pitch D_L and the effective focal length D_EFL of the lens 140 can determine the fan-out angle θ, which affects how a dot pattern are shifted compared to each other.

Assuming that the effective focal length D_EFL is 2mm and the light source pitch is 30µm, the lens pitch D_M of diffracting unit 160 (if the diffracting unit 160 is a MLA) or the cell pitch D_E of the diffracting unit 160 can be determined by:

$$N \times \sin\left[\tan^{-1}\left(\frac{D\_L}{D\_EFL}\right)\right] = \frac{\lambda}{D\_M}$$

or

$$N \times \sin\left[\tan^{-1}\left(\frac{D\_L}{D\_EFL}\right)\right] = \frac{\lambda}{D\_E}.$$

Therefore, the lens pitch D_M or the cell pitch D_E of diffracting unit 160 will be around 62.7µm when N=1 (i.e., the overlapping-type) or 31.3µm when N=2 (i.e., the interlacing-type).

Furthermore, to implement an illumination pattern covering a field of interest (FOI): 60°(H) by 40°(V), dimensions of the illumination pattern can be determined by:

$$D\_M \times \sin\left(\theta_{m_H}\right) = m_H \times \lambda \, ;$$

and

$$D\_M \times \sin\left(\theta_{m_V}\right) = m_V \times \lambda \, ;$$

where $\theta_{mH}$=(60/2) and $\theta_{mV}$=(40/2). Therefore, in the overlapping-type (N=1), the diffraction order in the horizontal direction $m_H$ will be ±33, and the diffraction order in the vertical direction $m_V$ will be ±22. In in the interlaced-type (N=2), the diffraction order in the horizontal direction $m_H$ will be ±16, and the diffraction order in the vertical direction $m_V$ will be ±11. Accordingly, a total number of dots in the illumination pattern can be determined by:

$$N^2 \times \left(2\left|m_H\right| + 1\right) \times \left(2\left|m_V\right| + 1\right).$$

In the case where N=1, $m_H$ = ±33 and $m_V$ = ±22, the total number of dots will be around 3015, while in the case where N=2, $m_H$ = ±16 and $m_V$ = ±11, the total number of dots will be around 3036. In view of this, it is possible to change the lens pitch D_M (or cell pitch D_M) in conjunction with the interlacing factor "N" to render similar number of dots in a given FOI. This significantly improves flexibility of design and fabrication of the diffracting unit 160.

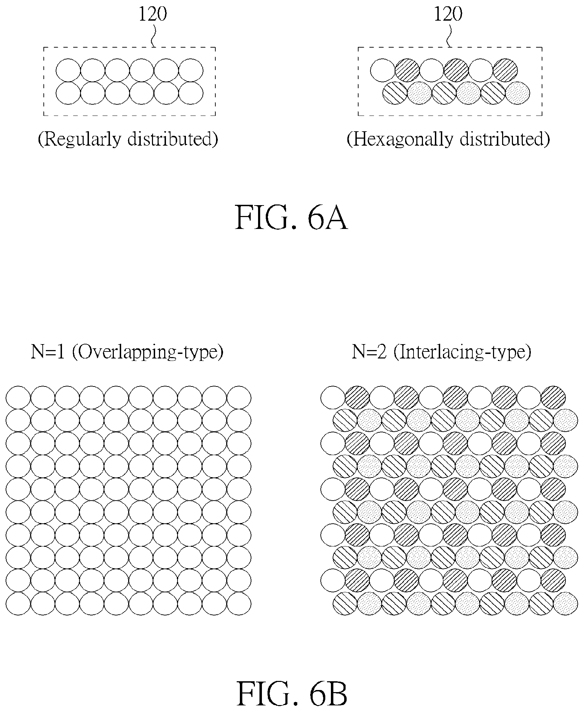

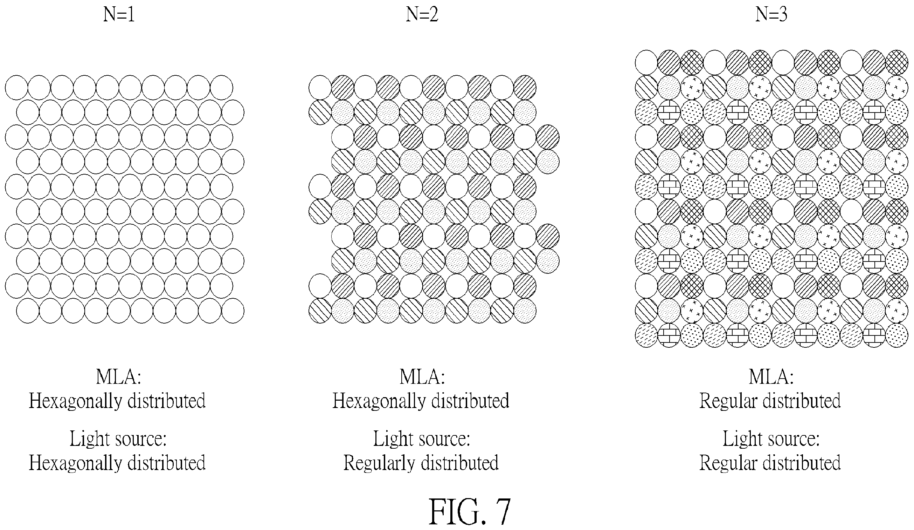

FIG. 6A and FIG. 6B illustrate arrangements of different light source arrays 120 and their corresponding illumination patterns. As illustrated by drawing, distributions of dots in the illumination patterns inherits distributions of the light sources in the light source array 120. FIG. 7 illustrates illumination patterns with respect to combinations of different light source arrangements, unit lens arrangements of MLA, and different interlacing types.

In conclusion, embodiments of the present invention provide a dot pattern projector for use in a three-dimensional optical distance measurement system. The dot pattern projector of the present invention can be used in conjunction with a flood illuminator in an optical distance measurement system, thereby to provide high-power illumination patterns and considerably long distance of projection. Both of a diffuser of the flood illuminator and a diffracting unit of the dot pattern projector can be implemented with same types of optical elements (e.g. both are MLA or DOE), thereby simplifying fabrication of the optical distance measurement system. Moreover, eembodiments of the present invention allow dot patterns produced by different light sources of a light source array to be overlapped or interlaced, such that parameters of components of the dot pattern projector could have wide ranges of adjustment. This significantly improves the flexibility of the design and the fabrication of the dot pattern projector.

**Claims**

1. A dot pattern projector (100), **characterized by:**

   a light source array (120), including a plurality of light sources (120_1-120_N) that emit light beams;
   a lens (140), configured to collimate the light beams; and
   a diffracting unit (160), configured to diffract the collimated light beams thereby to project an illumination pattern;
   wherein the illumination pattern is formed by overlapping multiple dot patterns that are projected by different light sources (120_1-120_N) or interlacing multiple dot patterns that are projected by the light sources.

2. The dot pattern projector (100) of claim 1, **characterized in that** each of the light sources (120_1-120_N) is a vertical-cavity surface-emitting laser (VCSEL).

**3.** The dot pattern projector (100) of claim 1, **characterized in that** a light source pitch (D_L) between two neighbor light sources (120_1-120_N) is regular.

**4.** The dot pattern projector (100) of claim 1, **characterized in that** the light sources (120_1-120_N) are regularly distributed or hexagonally distributed within the light source array (120).

**5.** The dot pattern projector (100) of claim 1, **characterized in that** the diffracting unit (160) comprises a microlens array (MLA) or a diffractive optical element (DOE).

**6.** The dot pattern projector (100) of claim 1, **characterized in that** a distance between of the light source array (120) and an optical center of the lens (140) is identical to an effective focal length (D_EFL) of the lens (140).

**7.** The dot pattern projector (100) of claim 1, **characterized in that** if a wavelength of the light beams emitted by the light sources (120_1-120_N) is $\lambda$, a fan-out angle between a dot of the zero-order diffraction and a dot of the mth-order diffraction in the dot pattern projected by a light source is $\theta_m$, and a cell pitch or a lens pitch of the diffracting unit (160) is D M, the above-mentioned parameters will have a relationship of: $D\_M \times \sin\theta_m = m\lambda$.

**8.** The dot pattern projector (100) of claim 1, **characterized in that** if a light source pitch between two neighboring light sources (120_1-120_N) is D_L, an effective focal length of the lens (140) is D EFL, a deviation angle between an optical axis of the lens (140) and a collimated light beam of a light source that is not positioned at the optical axis is $\alpha$, the above-mentioned parameters have a relationship of:

$$\alpha = \tan^{-1}\left(\frac{D\_L}{D\_EFL}\right).$$

**9.** The dot pattern projector (100) of claim 1, **characterized in that** if the illumination pattern is formed by overlapping the dot patterns projected by different light sources (120_1-120_N), a deviation angle between an optical axis of the lens (140) and a collimated light beam of a light source that is not positioned at the optical axis is and a fan-out angle between a dot of zero-order diffraction and a dot of 1st-order diffraction in the dot pattern projected by a light source is $\theta_1$, the above-mentioned parameters have a relationship of: $\sin\alpha = \sin\theta_1$.

**10.** The dot pattern projector (100) of claim 1, **characterized in that** if the illumination pattern is formed by interlacing the dot patterns projected by different light sources (120_1-120_N), a deviation angle between an optical axis of the lens (140) and a collimated light beam of a light source that is not positioned at the optical axis is $\alpha$ and a fan-out angle between a dot of zero-order diffraction and a dot of 1st-order diffraction in the dot pattern projected by a light source is $\theta_1$, the above-mentioned parameters have a relationship of: $N \times \sin\alpha = \sin\theta_1$.

**11.** An optical distance measurement system (1), **characterized by:**

a flood illuminator (200), including at least one light source (220) and a diffuser (260), configured to project a first illumination pattern;
a dot pattern projector (100), configured to project a second illumination pattern, comprising:

a light source array (120) including a plurality of light sources (120_1-120_N) that emit light beams;
a lens (140), configured to collimate the light beams; and
a diffracting unit (160), configured to diffract the collimated light beams thereby to project an illumination pattern, wherein the illumination pattern is formed by overlapping multiple dot patterns that are projected by different light sources (120_1-120_N) or interlacing multiple dot patterns that are projected by different light sources (120_1-120_N); and

an image capturing device (300), configured to capture images of illumination pattern reflected from an object.

**12.** The optical distance measurement system (1) of claim 11, **characterized in that** both of the diffuser (260) and the diffracting unit (160) comprise microlens arrays.

**13.** The optical distance measurement system (1) of claim 11, **characterized in that** both of the diffuser (260) and the diffracting unit (160) comprise diffractive optical elements.

**Amended claims in accordance with Rule 137(2) EPC.**

**1.** A dot pattern projector (100), comprising:

a light source array (120), including a plurality of light sources (120_1-120_N) that emit light beams;
a lens (140), configured to collimate the light beams; and
a diffracting unit (160), configured to diffract the collimated light beams thereby to project an illumination pattern;
**characterized**:

in that the illumination pattern is formed by interlacing multiple dot patterns that are projected by the light sources (120_1-120_N), and

by a relationship of: $N \times \sin \alpha = \sin \theta_1$, wherein a deviation angle between an optical axis of the lens (140) and a collimated light beam of a light source that is not positioned at the optical axis is $\alpha$ and a fan-out angle between a dot of zero-order diffraction and a dot of 1st-order diffraction in the dot pattern projected by a light source is $\theta_1$ and wherein N = 2.

2. The dot pattern projector (100) of claim 1, **characterized in that** each of the light sources (120_1-120_N) is a vertical-cavity surface-emitting laser (VCSEL).

3. The dot pattern projector (100) of claim 1, **characterized in that** a light source pitch (D_L) between two neighbor light sources (120_1-120_N) is regular.

4. The dot pattern projector (100) of claim 1, **characterized in that** the light sources (120_1-120_N) are regularly distributed or hexagonally distributed within the light source array (120).

5. The dot pattern projector (100) of claim 1, **characterized in that** the diffracting unit (160) comprises a microlens array (MLA) or a diffractive optical element (DOE).

6. The dot pattern projector (100) of claim 1, **characterized in that** a distance between the light source array (120) and an optical center of the lens (140) is identical to an effective focal length (D_EFL) of the lens (140).

7. The dot pattern projector (100) of claim 1, **characterized by** a relationship of: $D\_M \times \sin \theta_m = m\lambda$, wherein a wavelength of the light beams emitted by the light sources (120_1-120_N) is $\lambda$, a fan-out angle between a dot of the zero-order diffraction and a dot of the mth-order diffraction in the dot pattern projected by a light source is $\theta_m$, and a cell pitch or a lens pitch of the diffracting unit (160) is D_M.

8. The dot pattern projector (100) of claim 1, **characterized by** a relationship of:

$$\alpha = \tan^{-1}\left(\frac{D\_L}{D\_EFL}\right)$$ , wherein a light source pitch between two neighboring light sources (120_1-120_N) is D_L, an effective focal length of the lens (140) is D_EFL, a deviation angle between an optical axis of the lens (140) and a collimated light beam of a light source that is not positioned at the optical axis is $\alpha$.

9. An optical distance measurement system (1), **characterized by**:

a flood illuminator (200), including at least one light source (220) and a diffuser (260), configured to project a first illumination pattern;
a dot pattern projector (100) of any of the preceding claims, configured to project a second illumination pattern; and
an image capturing device (300), configured to capture images of illumination pattern reflected from an object.

10. The optical distance measurement system (1) of claim 9, **characterized in that** both of the diffuser (260) and the diffracting unit (160) comprise microlens arrays.

11. The optical distance measurement system (1) of claim 9, **characterized in that** both of the diffuser (260) and the diffracting unit (160) comprise diffractive optical elements.

**Optical Distance Measurement System** 10

**Dot Pattern Projector** 100

Light Source Array 120

Lens 140

Diffracting Unit 160

Image Capturing Device 300

Flood Illuminator 200

# FIG. 1

FIG. 2

FIG. 3

EP 4 109 039 A1

FIG. 4A

EP 4 109 039 A1

D_P

Projected by 120_1

FIG. 4B

D_P

Projected by 120_2

FIG. 4C

D_P

Projected by 120_3

FIG. 4D

D_P

Projected by 120_4

FIG. 4E

FIG. 5A

D_P

Projected by 120_1

## FIG. 5B

1/2*D_P
Projected by 120_2

## FIG. 5C

1/2*D_P

Projected by 120_3

## FIG. 5D

1/2*D_P

1/2*D_P
Projected by 120_4

## FIG. 5E

120

(Regularly distributed)  (Hexagonally distributed)

# FIG. 6A

N=1 (Overlapping-type)  N=2 (Interlacing-type)

# FIG. 6B

N=1            N=2            N=3

MLA:
Hexagonally distributed

Light source:
Hexagonally distributed

MLA:
Hexagonally distributed

Light source:
Regularly distributed

MLA:
Regular distributed

Light source:
Regular distributed

FIG. 7

EP 4 109 039 A1

Europäisches
Patentamt

European
Patent Office

Office européen
des brevets

# EUROPEAN SEARCH REPORT

Application Number

**EP 21 21 1062**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/178915 A1 (MOR ZAFRIR [IL] ET AL) 23 June 2016 (2016-06-23) | 1-10 | INV. G01B11/25 G02B27/09 |
| Y | * abstract; figures 1-5 * <br> * paragraphs [0016] – [0025], [0035] – [0036] * | 11-13 | |
| Y | US 2019/068853 A1 (PRICE RAYMOND KIRK [US] ET AL) 28 February 2019 (2019-02-28) * abstract; figure 7 * * paragraphs [0034] – [0038], [0050] – [0052] * | 11-13 | |
| Y | US 2016/356484 A1 (SAWYER KEVIN A [US] ET AL) 8 December 2016 (2016-12-08) * paragraph [0027]; figure 1 * | 12 | |
| X | CN 107 589 623 A (SHENZHEN ORBBEC SCIENCE & TECH CO LTD) 16 January 2018 (2018-01-16) | 1-10 | |
| Y | * abstract; figures 1-5 * * paragraphs [0029] – [0034] * | 11-13 | TECHNICAL FIELDS SEARCHED (IPC) <br><br> G01B <br> G02B |

The present search report has been drawn up for all claims

| Place of search | Date of completion of the search | Examiner |
|---|---|---|
| Munich | 9 May 2022 | Marani, Roberta |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 21 21 1062

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2022

| Patent document cited in search report | | Publication date | Patent family member(s) | | Publication date |
|---|---|---|---|---|---|
| US 2016178915 | A1 | 23-06-2016 | US | 2016178915 A1 | 23-06-2016 |
| | | | US | 2018292200 A1 | 11-10-2018 |
| | | | US | 2019226838 A1 | 25-07-2019 |
| US 2019068853 | A1 | 28-02-2019 | US | 2019068853 A1 | 28-02-2019 |
| | | | WO | 2019040174 A1 | 28-02-2019 |
| US 2016356484 | A1 | 08-12-2016 | CN | 107636508 A | 26-01-2018 |
| | | | EP | 3259643 A1 | 27-12-2017 |
| | | | HK | 1248320 A1 | 12-10-2018 |
| | | | US | 2016356484 A1 | 08-12-2016 |
| | | | WO | 2016195791 A1 | 08-12-2016 |
| CN 107589623 | A | 16-01-2018 | NONE | | |

EPO FORM P0459

For more details about this annex : see Official Journal of the European Patent Office, No. 12/82